Europäisches Patentamt

European Patent Office

Office européen des brevets

(19)

(11) Veröffentlichungsnummer: **0 102 058**
**A2**

(12) # EUROPÄISCHE PATENTANMELDUNG

(21) Anmeldenummer: 83108341.5

(22) Anmeldetag: 24.08.83

(51) Int. Cl.³: **H 01 L 23/32**
**H 01 L 23/30, H 01 L 25/04**
**H 01 L 21/60**

(30) Priorität: 30.08.82 DE 3232168

(43) Veröffentlichungstag der Anmeldung:
07.03.84 Patentblatt 84/10

(84) Benannte Vertragsstaaten:
DE FR GB IT

(71) Anmelder: SIEMENS AKTIENGESELLSCHAFT
Berlin und München Wittelsbacherplatz 2
D-8000 München 2(DE)

(72) Erfinder: Heidegger, Peter, Dr.rer.nat.
Kunihohstrasse 16
D-8000 München 81(DE)

(72) Erfinder: Kiefer, Jakob
Regattaweg 94
D-8000 München 50(DE)

(54) Halbleiterbauelement mit Druckkontakt.

(57) Bei mit Vergußmasse (19) gefüllten Gehäusen besteht das Problem, daß diese die Qualität des Druckkontaktes dadurch beeinträchtigt, daß sie beim Aushärten auf die Feder (16) Kräfte ausübt. Eine Verbesserung des Druckkontaktes wird erreicht, indem die Feder (16) an denjenigen Fläche, an denen sie mit der Vergußmasse (19) in Berührung steht, mit einer dauerelastischen Kunstharzmasse (20) beschichtet ist.

EP 0 102 058 A2

SIEMENS AKTIENGESELLSCHAFT
Berlin und München

Unser Zeichen
VPA 82 P 1 7 2 0 E

Halbleiterbauelement mit Druckkontakt

Die Erfindung bezieht sich auf ein Halbleiterbauelement mit mindestens einem in einem Gehäuse eingeschlossenen Halbleiterkörper, dessen eine Hauptfläche zumindest in thermischem Kontakt mit einem Metallboden steht, mit mindestens einer Zuführungselektrode, die mit der anderen Hauptfläche des Halbleiterkörpers in Kontakt steht, mit einer im Metallboden verankerten Feder, die die miteinander in Kontakt stehenden Teile aneinander preßt, und mit einer das Gehäuse mindestens teilweise füllenden Vergußmasse.

Ein solches Halbleiterbauelement ist beispielsweise in der DE-OS 27 28 315 beschrieben worden. Messungen nach Belastungstests haben ergeben, daß nach dem Vergießen und Aushärten der Vergußmasse eine Erhöhung des Wärmewiderstandes und Instabilitäten der Durchlaßkennlinie auftreten. Es wurde ermittelt, daß dies durch mechanische Kräfte verursacht wurde, die das ausgehärtete Gießharz auf die Feder ausübte. Beim bekannten Halbleiterbauelement hat man sich daher damit begnügt, das Gehäuse nur bis unterhalb der Feder mit Vergußmasse zu füllen.

Im Interesse einer besseren Ausschaltung der Umgebungseinflüsse soll das Gehäuse jedoch möglichst vollständig mit Vergußmasse gefüllt sein. Die der Erfindung zugrunde liegende Aufgabe besteht daher darin, ein Halbleiterbauelement der genannten Gattung so weiterzubilden, daß die Einwirkung von von der Vergußmasse auf die Feder ausgeübten Kräften auch dann ausgeschlossen ist, wenn das Gehäuseinnere bis über die Feder mit der Vergußmasse gefüllt ist.

Hab 1 Va / 24.08.1982

Diese Aufgabe wird dadurch gelöst, daß die Feder in der Vergußmasse sitzt und daß diejenigen Flächen der Feder, die mit der Vergußmasse in Berührung stehen, mindestens teilweise mit einer dauerelastischen Kunstharzmasse beschichtet sind.

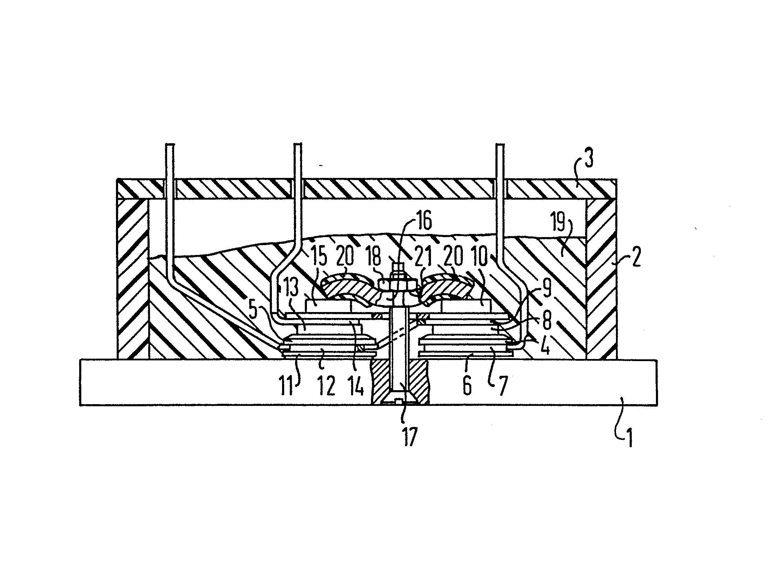

Weiterbildungen sind Gegenstand der Unteransprüche. Die Erfindung wird anhand eines Ausführungsbeispiels in Verbindung mit der Figur näher erläutert. Diese Figur zeigt eine Seitenansicht auf das Halbleiterbauelement mit aufgeschnittenem Gehäuse.

Das Halbleiterbauelement hat ein Gehäuse, das aus einem Metallboden 1, einem Rahmen 2 und einem Deckel 3 besteht. Dieses Gehäuse schließt zwei Halbleiterkörper 4 und 5 ein, die in thermischem Kontakt mit dem Metallboden 1 stehen. Die Halbleiterkörper können, müssen aber nicht gegen den Metallboden 1 elektrisch isoliert sein. Zur eventuellen elektrischen Isolierung werden sie auf Substratplättchen 6, 11 montiert, die z.B. aus Berylliumoxid bestehen. Auf dem Metallboden 1 sind im Ausführungsbeispiel zwei Stapel angeordnet, die von unten nach oben folgende Teile enthalten: das Substratplättchen 6 bzw. 11, eine Zuleitung 7 bzw. 12, der Halbleiterkörper 4 bzw. 5, eine Kontaktelektrode 8 bzw. 13, eine Zuleitung 9 bzw. 14 und ein Druckstück 10 bzw. 15. Die Druckstücke 10, 15 werden durch eine Feder 16 belastet, die über eine Schraube 17 und eine Mutter 18 mit dem Metallboden 1 verankert ist. Das Gehäuse ist mit einer Vergußmasse 19 bis über die Feder 16 gefüllt. Die Feder 16 ist mit einer dauerelastischen Kunstharzmasse 20 beschichtet, die mindestens einen Teil derjenigen Flächen der Feder bedeckt, die mit der Vergußmasse 19 in Berührung stehen. Wesentlich ist, daß die mit den Druckstücken 10, 15 sowie die mit der

0102058

- 3 -          VPA 82 P 1720 E

Mutter 18 in Berührung stehenden Flächen der Feder nicht
beschichtet sind, da sonst eine exakte Einstellung der
Federkraft nicht gewährleistet ist. Die der Mutter 18
gegenüberliegende Fläche der Feder kann ebenfalls frei
von der Beschichtung bleiben, da in diesem Bereich die
von der Vergußmasse ausgeübten Kräfte keinen wesentlichen Einfluß auf die Federkraft haben. Als Feder kann
z.B. eine Blattfeder oder eine Tellerfeder verwendet
werden.

Der Federdruck wird durch ein Spannwerkzeug eingestellt,
das auf eine vorzugsweise ebene, senkrecht zur Zeichnungsebene vor und hinter der Mutter liegende Fläche der Blattfeder aufgesetzt wird. Auch diese Fläche bleibt frei von
der Beschichtung.

Als dauerelastische Kunstharzmasse kommt vorzugsweise ein
Silikonkautschuk zur Anwendung. Dies kann z.B. mit einer
Stärke von wenigen 100 /um durch einfaches Eintauchen in
noch nicht polymerisierten Silikonkautschuk geschehen.

Die Erfindung wurde anhand eines Ausführungsbeispiels mit
zwei Halbleiterkörpern erläutert. Es ist jedoch z.B.
auch möglich, den Kontaktdruck für einen einzigen Halbleiterkörper durch eine Blattfeder aufzubringen, die in
der Mitte auf dem Halbleiterkörper bzw. einem Druckstück
aufliegt. Diese Blattfeder kann dann durch zwei Schrauben
gehaltert werden, die die Enden der Blattfeder durchsetzen. Es ist auch denkbar, mehr als zwei Halbleiterkörper z.B. durch eine Tellerfeder zu kontaktieren, deren
Rand ringsum mit der dauerelastischen Kunstharzmasse beschichtet ist.

1 Figur

3 Patentansprüche

BAD ORIGINAL

**0102058**

Patentansprüche

1. Halbleiterbauelement mit mindestens einem in einem Gehäuse eingeschlossenen Halbleiterkörper, dessen eine Hauptfläche zumindest in thermischem Kontakt mit einem Metallboden steht, mit mindestens einer Zuführungselektrode, die mit der anderen Hauptfläche des Halbleiterkörpers in Kontakt steht, mit einer im Metallboden verankerten Feder, die die miteinander in Kontakt stehenden Teile aneinander preßt, und mit einer das Gehäuse mindestens teilweise füllenden Vergußmasse, d a d u r c h g e k e n n z e i c h n e t , daß die Feder (16) in der Vergußmasse (19) sitzt und daß diejenigen Flächen der Feder, die mit der Vergußmasse in Berührung stehen, mindestens teilweise mit einer dauerelastischen Kunstharzmasse (20) beschichtet sind.

2. Halbleiterbauelement nach Anspruch 1, d a d u r c h g e k e n n z e i c h n e t , daß die Feder eine Blattfeder ist, die eine zum Aufsetzen eines Spannwerkzeugs bestimmte Fläche (21) hat, und daß diese Fläche frei von der dauerelastischen Kunstharzmasse ist.

3. Halbleiterbauelement nach Anspruch 1 oder 2, d a - d u r c h g e k e n n z e i c h n e t , daß die Kunstharzmasse (20) ein Silikonkautschuk ist.